(19) Europäisches Patentamt
European Patent Office
Office européen des brevets

(11) **EP 3 014 233 B1**

(12) **EUROPÄISCHE PATENTSCHRIFT**

(45) Veröffentlichungstag und Bekanntmachung des Hinweises auf die Patenterteilung:
**13.09.2017 Patentblatt 2017/37**

(21) Anmeldenummer: **14728916.9**

(22) Anmeldetag: **03.06.2014**

(51) Int Cl.:
***H02P 3/04*** *(2006.01)*

(86) Internationale Anmeldenummer:
**PCT/EP2014/061442**

(87) Internationale Veröffentlichungsnummer:
**WO 2014/206691 (31.12.2014 Gazette 2014/53)**

(54) **VERFAHREN ZUR FUNKTIONSPRÜFUNG EINER HALTEBREMSE EINES ELEKTROMOTORS**

METHOD FOR THE FUNCTIONAL TESTING OF A HOLDING BRAKE OF AN ELECTRIC MOTOR

PROCÉDÉ DE CONTRÔLE FONCTIONNEL D'UN FREIN D'ARRÊT DE MOTEUR ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.06.2013 AT 504142013**

(43) Veröffentlichungstag der Anmeldung:
**04.05.2016 Patentblatt 2016/18**

(73) Patentinhaber: **Bernecker+Rainer Industrie-Elektronik Gesellschaft MbH**
**5142 Eggelsberg 120 (AT)**

(72) Erfinder: **PÖLZLEITHNER, Andreas**
**A-5310 Tiefgraben (AT)**

(74) Vertreter: **Patentanwälte Pinter & Weiss OG**
**Prinz-Eugen-Straße 70**
**1040 Wien (AT)**

(56) Entgegenhaltungen:
**DE-A1- 19 756 752      DE-A1-102005 015 608**
**DE-A1-102007 005 827**

**Beschreibung**

Die gegenständliche Erfindung betrifft ein Verfahren zur Funktionsprüfung einer Haltebremse eines Elektromotors, bei dem bei geschlossener Haltebremse zur Erzeugung eines Stromraumzeigers in Betrag und Winkel Phasenströme an den Elektromotor angelegt werden und überprüft wird, ob die Haltebremse bei angelegten Phasenströmen durchrutscht.

In vielen Maschinen werden bewegte Maschinenteile von Elektromotoren angetrieben. Oftmals sind auch Haltebremsen vorgesehen, um eine bewegte Achse der Maschine in der Lage zu fixieren. Die Haltebremse kann dabei als separater Bauteil ausgeführt sein, oder kann auch im Elektromotor integriert sein. Die Funktion der Haltebremse, speziell in sicherkritischen Bereichen, muss dabei sichergestellt sein, um Schaden an Mensch und Maschine zu verhindern. Die Haltebremse unterliegt aber Verschleiß, z.B. der Bremsbeläge, die das Bremsverhalten verändern. Abgesehen davon kann die Haltebremse durch äußere Verschmutzung, z.B. durch Öl, oder durch Beschädigung in ihrer Funktion beeinträchtigt werden. Deshalb sind regelmäßige Funktionstests der Haltebremse erforderlich, z.B. in regelmäßigen Zeitabständen oder immer vor einer bestimmten Bewegung der Maschine, um sicherzustellen, dass die Haltebremse noch ausreichende Bremswirkung aufbringen kann. Falls die Haltebremse den Funktionstest nicht besteht, wird die Maschine in der Regel stillgesetzt.

In der DE 10 2005 015 608 A1 wird dazu ein Verfahren vorgeschlagen, bei dem der Elektromotor der angetriebenen Achse mit einem Drehmoment angesteuert wird und über den Wegmessgeber des Antriebs überprüft wird, ob die Haltebremse in der Lage ist, das Drehmoment zu halten. Ein Durchrutschen der Haltebremse wird dabei als Versagen der Haltebremse interpretiert. Das Drehmoment wird dazu stufenweise erhöht, bis die Haltebremse durchrutscht und das letzte gehaltene Drehmoment wird als maximale Haltekraft der Haltebremse angesehen, das mit einer bestimmten Nenn-Haltekraft verglichen werden kann.

Die DE 10 2007 005 827 A1 beschreibt ein Verfahren für einen Funktionstest einer Haltebremse eines Elektromotors, der eine schwebende Last bewegt. Um die Last beim Funktionstest berücksichtigen zu können, wird hier zuerst die Wirkung der Last ermittelt, in dem der Elektromotor so angesteuert wird, dass die Last bei offener Bremse unbewegt bleibt. Der dazu notwendige Motorstrom wird als Referenzwert gespeichert. Anschließend wird der Elektromotor bei geschlossener Bremse mit einem Vielfachen dieses Referenzwertes angesteuert und über einen Winkelsensor überprüft, ob sich der Antrieb bewegt.

Auch in der DE 197 56 752 A1 wird ein Funktionstest einer Haltebremse beschrieben, bei der bei geschlossener Haltebremse ein Anlaufstrom angelegt wird, der ein bestimmtes Drehmoment bewirkt. Eine Drehung des Rotors des Elektromotors und damit eine nicht ordnungsgemäße Haltebremse kann durch Erfassen der Motorspannung oder mittels eines Drehgeber erkannt werden.

In diesem Stand der Technik wird bei geschlossener Haltebremse folglich ein Motorstrom angelegt, um ein bestimmtes Drehmoment hervorzurufen. Insbesondere bei mehrphasigen Elektromotoren muss der Motorstrom bei festgehaltenem Elektromotor aber vektoriell (in Betrag und Winkel) richtig angelegt werden, um das erwartete Drehmoment zu erzeugen. Der Statorstrom ergibt sich aus der vektoriellen Addition der einzelnen Phasenströme und wird als Stromraumzeiger $i_s$ bezeichnet. Durch die bekannte Clarke- bzw. Park-Transformation kann der Stromraumzeiger in das statorfeste $\alpha j\beta$-Koordinatensystem bzw. in das rotorfeste dq-Koordinatensystem transformiert werden. Für die Park-Transformation wird die absolute Lage des Rotors im Bezug zum Stator benötigt, welche in der Regel mit einem Winkelmessgerät gemessen wird. Bei Verwendung des rotorfesten Koordinatensystems dq wird davon ausgegangen, dass der Stromraumzeiger im rotorfesten dq-Koordinatensystem ausschließlich eine Momenten bildende q-Komponente (normal zur Rotorflussrichtung d) aufweist. Dies wird durch die Antriebsregelung sichergestellt, sodass sich der Statorstrom mit dem rotorfesten dq-Koordinatensystem mit dreht.

Aufgrund fehlerhafter Kommutierung, Fehler in der Motorsteuerung oder Fehler in der Antriebsregelung kann der tatsächliche Stromraumzeiger aber auch eine d-Komponente enthalten. Das bedeutet, dass die q-Komponente kleiner ist als der Betrag des Stromraumzeigers, womit das Drehmoment, im Betrag kleiner ist, als angenommen bzw. vorgegeben. Hinsichtlich des Bremsentests bedeutet das aber, dass nur bei korrekter Kommutierung, und bei keinem Auftreten eines Fehlers, davon ausgegangen werden kann, dass der angelegte Statorstrom bzw. die angelegten Phasenströme, die gemessen werden können oder bekannt sind, proportional zum Drehmoment an der Motorwelle ist.

Z.B. muss ein Winkelfehler $\upsilon_{err}$ zwischen dem wirklichen rotorfesten d'q'-Koordinatensystem (d' zeigt in Flussrichtung des Rotors) und dem angenommenen dq-Koordinatensystem unterstellt werden. Es gilt für einen permanentmagneterregten Synchronmotor in Vektorregelung $M=K_T\ i_s \cos \upsilon_{err}$. Im Idealfall ist $\upsilon_{err}=0$ und damit das Drehmoment M über die Motorkonstante $K_T$ direkt proportional zum momentbildenden Stromanteil (Statorstrom). Im Fehlerfall ist aber $\upsilon_{err}\neq0$, womit sich ein betragsmäßig kleineres Drehmoment ergibt. D.h., dass ein Bremsentest zur Funktionsprüfung einer Haltebremse auf Basis der gemessenen Phasenströme bzw. des sich daraus ergebenden vektoriellen Stromraumzeigers $i_s$ wie im Stand der Technik nicht ausreichend sicher ist.

Es ist daher eine Aufgabe der gegenständlichen Erfindung, die Sicherheit einer Funktionsprüfung einer Haltebremse eines Elektromotors zu verbessern.

Diese Aufgabe wird erfindungsgemäß dadurch gelöst, indem die Phasenströme variiert werden, sodass der Stromraumzeiger bei geschlossener Haltebremse gedreht wird, damit der Stromraumzeiger zumindest einmal normal zur Rotorflussrichtung steht. Auf diese Weise kann garantiert werden, dass zumindest einmal das gewünschte Moment zur Funktionsprüfung der Haltebremse wirklich anliegt.

Im einfachsten Fall, wenn keine externe Last anliegt, reicht es aus, wenn der Stromraumzeiger um einen Winkel von zumindest 180° rotiert wird. Im Falle einer externen Last oder einer Funktionsprüfung mit einem Moment in eine bestimmte Richtung wird der Stromraumzeiger um einen Winkel von zumindest 360° rotiert.

Für die Funktionsprüfung ist es vorteilhaft, wenn die elektrische Periode in Sektoren unterteilt wird und der Stromraumzeiger während der Funktionsprüfung in jedem Sektor für eine bestimmte Verweildauer verbleibt, da damit sichergestellt werden kann, dass sich das einzustellende Moment auch tatsächlich einstellt.

Die gegenständliche Erfindung wird nachfolgend unter Bezugnahme auf die Figuren 1 bis 8 näher erläutert, die beispielhaft, schematisch und nicht einschränkend vorteilhafte Ausgestaltungen der Erfindung zeigen. Dabei zeigt

Fig.1 einen typischen Antrieb mit Elektromotor, Last und Haltebremse,
Fig.2 den entstehenden Stromraumzeiger bei angelegten Phasenströmen,
Fig.3 und Fig.4 das Rotieren des Stromraumzeigers,
Fig.5 das Rotieren des Stromraumzeigers bei externer Last,
Fig.6 eine quasi-kontinuierliche und diskrete Rotation des Stromraumzeigers und
Fig.7 und Fig.8 die Einteilung der elektrischen Periode in Sektoren.

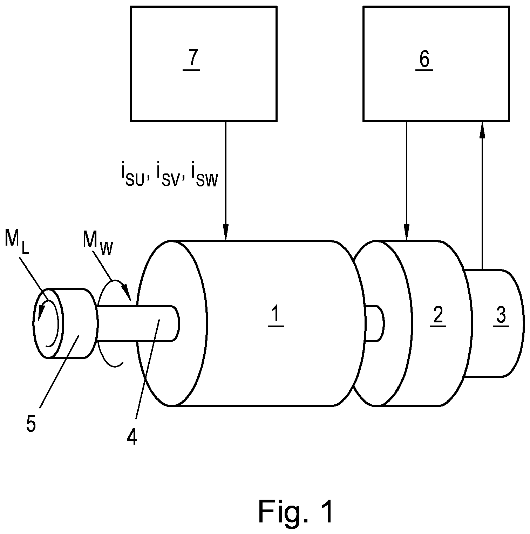

Fig.1 zeigt schematisch einen Antrieb mit einem Elektromotor 1, der über eine Motorwelle 4 mit einer Last 5 verbunden ist. Der Elektromotor 1 erzeugt ein Drehmoment $M_W$ an der Motorwelle 4 und die Last 5 ein Lastmoment $M_L$. An der Motorwelle 4, hier am anderen Ende des Elektromotors 1, ist eine Haltebremse 2, in beliebiger Ausführung, angeordnet. Ebenso ist ein Drehgeber 3 zur Messung des Drehwinkels vorgesehen. Die axiale Anordnung von Elektromotor 1, Haltebremse 2 und Drehgeber 3 kann natürlich beliebig geändert werden. Ebenso ist es denkbar, dass die Haltebremse 2 und/oder der Drehgeber 3 im Elektromotor 1 integriert sind, diese können aber auch auf eine andere Art mechanisch angebunden sein, z.B. über ein Getriebe.

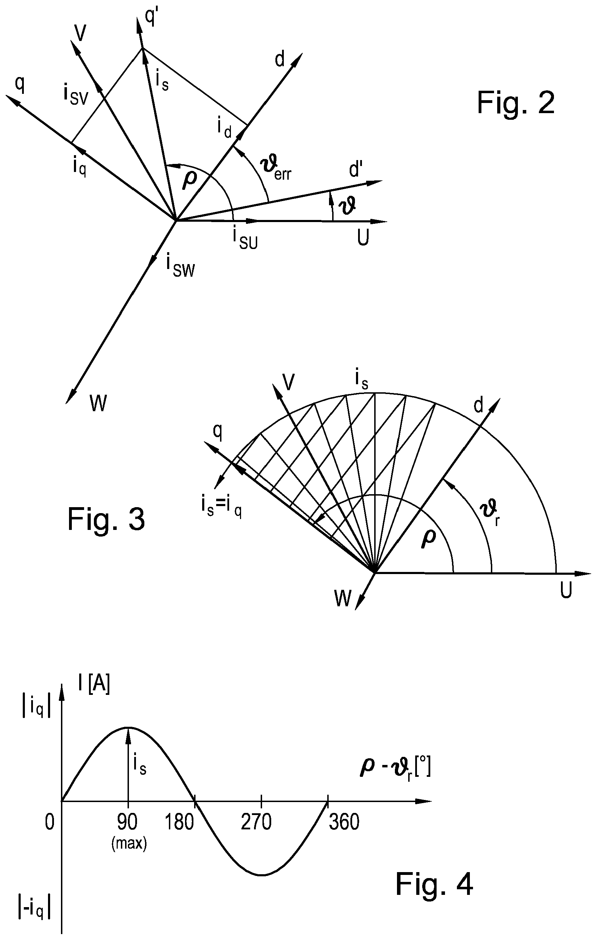

Eine Motorsteuerung 6 steuert den Elektromotor 1 über die Leistungselektronik 7, in der Regel ein Wechselrichter. Dazu kann von der Motorsteuerung 6 z.B. ein Drehmoment $M_W$ vorgegeben werden, das dann von der Leistungselektronik 7 in Phasenströme $i_{su}$, $i_{sv}$, $i_{sw}$ zur Erzeugung des Drehmoments $M_W$ umgesetzt wird. Die Phasenströme $i_{su}$, $i_{sv}$, $i_{sw}$ erzeugen einen Stromraumzeiger $i_s$ in Betrag und Winkel p, wie anhand von Fig.2 näher beschrieben.

Im Idealfall sollte der Stromraumzeiger $i_s$ der drehmomentbildenden Stromkomponente iq im rotorfesten Koordinatensystem dq in Betrag und Winkel entsprechen, also $i_s$ = iq sein. Aufgrund von Fehlern ergibt sich aber ein Fehler (Koordinatensystem d'q'), der dazu führt, dass der Statorstrom $i_s$ auch eine d-Komponente $i_{d'}$ beinhaltet. Damit gilt $i_{q'}$ = $i_s$ cos($\vartheta_{err}$) und die drehmomentbildende Stromkomponente iq und damit auch das Drehmoment $M_W$, welches vom Elektromotor 1 erzeugt wird und an der Motorwelle 4 anliegt, ist betragsmäßig kleiner als aufgrund der angelegten bzw. gemessenen Phasenströme $i_{su}$, $i_{sv}$, $i_{sw}$ erwartet.

Um das für den Funktionstest der Haltebremse 2 zu berücksichtigen ist nun vorgesehen, den Stromraumzeiger $i_s$, z.B. durch entsprechende Variation der Phasenströme $i_{su}$, $i_{sv}$, $i_{sw}$, bei geschlossener Haltebremse 2 so zu drehen, sodass sichergestellt ist, dass der Stromraumzeiger $i_s$ zumindest einmal ausschließlich in q-Richtung (normal zur Rotorflussrichtung d) zeigt und folglich zumindest einmal gilt $i_s$ = $i_q$, wie in Fig.3 dargestellt.

Des Weiteren können zwei Fälle unterschieden werden, nämlich ein Bremsentest ohne externe Last und ein Bremsentest mit externer Last (wie in Fig. 1 in Form des Lastmoment $M_L$ angedeutet).

Beim Bremsentest ohne externe Last reicht es aus, dass der Stromzeiger um 180° gedreht wird, falls die Richtung der Belastung irrelevant ist, um sicherzustellen, dass der Stromraumzeiger $i_s$ zumindest einmal ausschließlich in q-Richtung zeigt, wie aus Fig.4 hervorgeht. Sollte jedoch die Haltebremse 2 mit einem Moment in eine bestimmte Richtung getestet werden, muss der Stromraumzeiger $i_s$ auch in diesem Fall um 360° gedreht werden, um die Funktion der Haltebremse 2 sicher zu testen.

Der Statorstrom $i_s$ wird im Ausführungsbeispiel nach Fig.4 z.B. um 360° gedreht und auf die q-Achse des rotorfesten Koordinatensystems dq projiziert, in der Form $i_q = |i_s|\sin(\rho - \vartheta_r)$. Damit erreicht die drehmomentbildenden Stromkomponente iq zumindest einmal das Maximum $i_s$ = $i_q$, womit zumindest einmal das beabsichtigte Drehmoment $M_W$=$K_T$ $i_s$ zum Testen der Haltebremse 2 erzeugt wird.

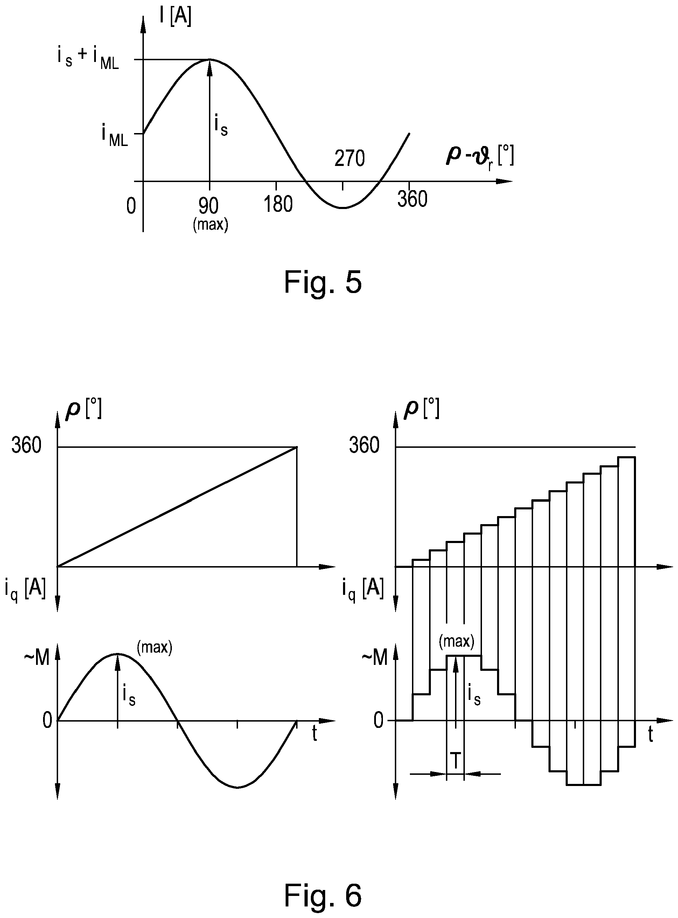

Falls mit dem Antrieb noch eine externe Last 5 verbunden ist, die ein bestimmtes Lastmoment $M_L$ bewirkt, erfährt die Haltebremse 2 bereits eine Grundbelastung. Diese Grundbelastung kann als momentenäquivalenter Strom $I_{ML}$ ausgedrückt werden. Um diesen Betrag wird das Drehmoment reduziert, welches der Antrieb während des Bremsentest aufbringen muss. Der momentenäquivalente Stromverlauf $i_{Test}$ aus Sicht der Haltebremse 2 ist die Summe aus der externen Grundbelastung $i_{ML}$ und dem Momenten bildenden Anteil des Statorstromes iq, $i_{Test}$ = $i_{ML}$ + $|i_s|\sin(\rho - \vartheta_{err})$, wie in Fig.5 dargestellt. Die externe Last 5 kann dabei als bekannt vorausgesetzt werden.

Wird der Stromraumzeiger $i_s$ um 360° gedreht,

durchläuft die drehmomentbildende Stromkomponente iq zumindest einmal das Maximum $i_s = i_q$.

Für den Funktionstest der Haltebremse 2 wird, z.B. über den Drehgeber 3 überprüft, ob die Haltebremse 2 während der Stromraumzeiger $i_s$ rotiert durchrutscht. Detektiert der Drehgeber 3 eine zu große Winkeländerung, wird das als Durchrutschen der Haltebremse 2 interpretiert und der Funktionstest mit einer Fehlermeldung, z.B. Setzen eines Statusbits, beendet. Welche Winkeländerung zulässig ist, kann dabei vorgegeben sein. Die Fehlermeldung kann z.B. an die Motorsteuerung 6 weitergeben werden, die dann eine geeignete Aktion setzen kann, z.B. Aktivieren eines Notaus, Meldung an eine übergeordnete Anlagensteuerung, Signalisieren des fehlgeschlagenen Funktionstests, etc. Der Funktionstest kann dabei natürlich ebenfalls von der Motorsteuerung 6 angestoßen und/oder ausgeführt werden. Es kann aber auch vorgesehen sein, dass der Funktionstest von einer anderen Einheit, z.B. einer sicheren Motorsteuerung, ausgeführt wird.

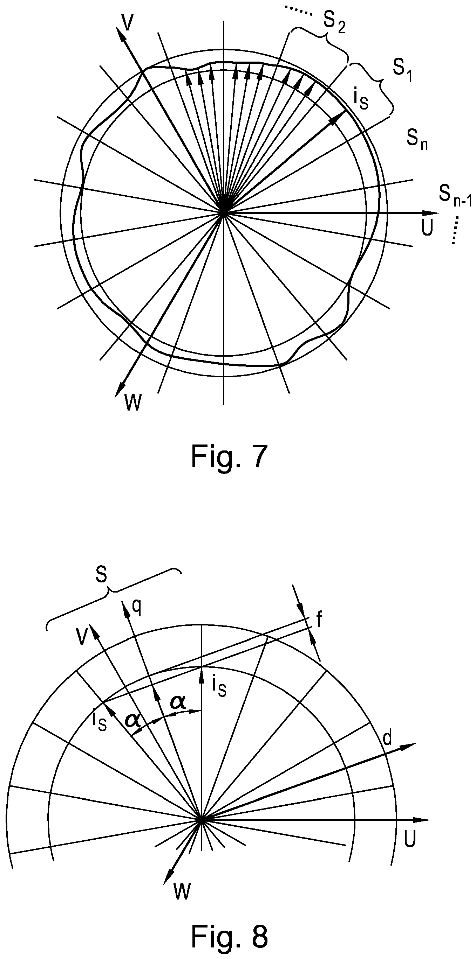

Für die konkrete Umsetzung des oben beschriebenen Funktionstest kann der Winkel p des Stromraumzeiger $i_s$ quasi-kontinuierlich oder in diskreten Schritten geändert werden, wie in Fig.6 und Fig. 7 dargestellt.

Die elektrische Periode (360°) wird dazu in n Sektoren $S_n$ unterteilt, z.B. achtzehn Sektoren wie in Fig.7 dargestellt. Für den Bremsentest ist nun vorgesehen, dass der Stromraumzeiger $i_s$ für einen gültigen Funktionstest in jedem Sektor $S_n$ für eine bestimmte Verweildauer verbleiben muss, damit sich das Drehmoment $M_W$ einstellen kann. Die Sektorengröße bzw. die Anzahl der Sektoren kann aus einem maximal tolerierbaren Fehler f bestimmt werden, wie anhand von Fig.8 erläutert. Damit gilt für die Sektorengröße $\alpha$ der Zusammenhang

$$\alpha = \pm \arccos(1 - \frac{f}{100})$$, wobei f in Prozent angegeben ist.

Es kann somit garantiert werden, dass während der Verweildauer in einem Sektor $S_n$ das maximale Drehmoment anliegt, abzüglich des Fehlers f, der abhängig von der Sektorengröße $\alpha$ ist. Je kleiner die unterteilenden Sektoren $S_n$ sind, desto geringer ist der maximale Fehler f, jedoch erhöht sich damit gleichzeitig die gesamte Testdauer, da der Stromraumzeiger $i_s$ in jedem Sektor $S_n$ verweilen muss. Es muss also ein sinnvoller Kompromiss zwischen Genauigkeit und Prüfdauer gefunden werden.

Die erforderliche Verweildauer ist abhängig von der Anwendung und der verwendeten Haltebremse 2 und muss entweder anhand den Herstellerangaben oder einer eigenen Berechnung eingestellt werden und obliegt dem Anwender. Selbiges gilt für das Winkeländerungstoleranzfenster.

Als Ansatz für die Berechnung kann das Momentengleichgewicht und die tolerierte Winkeländerungstoleranz herangezogen werden. Mit diesen Werten kann berechnet werden, wie lange ein Drehmoment anliegen muss, um die Trägheit des Rotors des Elektromotors 1 und gegebenenfalls einer Last 4 zu beschleunigen, um die minimal messbare Winkeländerung zurückzulegen.

Des Weiteren kann bei externer Last 5 vorgesehen werden, dass das Lastmoment $M_L$, welches die externe Last 5 im Stillstand aufbringt, ermittelt wird, z.B. mit einem Verfahren wie in der DE 10 2007 005 827 A1 beschrieben. Das Lastmoment $M_L$ kann aber für viele Anwendungen auch als bekannt vorausgesetzt werden. Nun kann ein Stromraumzeiger $i_s$ eingeprägt werden, der dem momentenäquivalenten Strom $I_{ML}$ des Lastmoments $M_L$ entspricht und das entstehende Drehmoment gemessen werden, oder überprüft werden, ob die externe Last bei diesem eingeprägten Stromraumzeiger $i_S$ im Stillstand ist. Dadurch kann z.B. durch Vergleich der bekannten externen Last 5 bzw. dem Lastmoment $M_L$ mit dem gemessenen Drehmoment die Kommutierung bzw. die Drehmomentenkonstante $K_T$ plausibilisiert wird, d.h. es kann auf diese Weise eine fehlerhafte Kommutierung erkannt werden, wenn die beiden Drehmomente voneinander abweichen.

Die obigen Ausführungen gelten in gleicher Weise auch für einen Linearmotor, da aus regelungstechnischer Sicht kein Unterschied zwischen drehendem Motor und einem Motor in linearer Ausführung besteht. Man kann sich den Linearmotor als "abgewickelten" Motor vorstellen. Die drei Wicklungen (Phasen) sind in der Regel (Kurzstatormotor) im Schlitten aneinandergereiht und erzeugen einen sinusförmigen "Strombelag" (magnetische Durchflutung) im Luftspalt. Die Permanentmagneten befinden sich aneinandergereiht im fixen Teil des Motors. Beim Langstatormotor ist es genau umgekehrt. Eine elektrische Umdrehung entspricht der Poolpaarlänge und wird intern umgerechnet, sodass auch hier von einer "Drehung des Stromraumzeigers" gesprochen werden kann. Der Stromraumzeiger steht dabei im Idealfall wieder quasi-normal auf die Flussrichtung. Die Drehmomentenkonstante ist hier äquivalent eine Kraftkonstante und der Linearmotor erzeugt kein Drehmoment M sondern eine Kraft F. Das Verfahren für die Funktionsprüfung einer Haltebremse kann daher gleichermaßen und äquivalenter Weise auch im Falle eines Linearmotors angewendet werden.

**Patentansprüche**

1. Verfahren zur Funktionsprüfung einer Haltebremse (2) eines Elektromotors (1), bei dem bei geschlossener Haltebremse (2) zur Erzeugung eines Stromraumzeigers ($i_s$) in Betrag und Winkel Phasenströme ($i_{su}$, $i_{sv}$, $i_{sw}$) an den Elektromotor (1) angelegt werden und überprüft wird, ob die Haltebremse (2) bei angelegten Phasenströmen ($i_{su}$, $i_{sv}$, $i_{sw}$) durchrutscht, **dadurch gekennzeichnet, dass** die Phasenströme ($i_{su}$, $i_{sv}$, $i_{sw}$) variiert werden, sodass der Stromraum-

zeiger ($i_s$) bei geschlossener Haltebremse (2) gedreht wird, damit der Stromraumzeiger ($i_s$) zumindest einmal normal zur Rotorflussrichtung (d) steht.

2. Verfahren nach Anspruch 1, **dadurch gekennzeichnet, dass** die Phasenströme ($i_{su}$, $i_{sv}$, $i_{sw}$) variiert werden, sodass der Stromraumzeiger ($i_s$) um einen Winkel von zumindest 180° rotiert.

3. Verfahren nach Anspruch 1, **dadurch gekennzeichnet, dass** die Phasenströme ($i_{su}$, $i_{sv}$, $i_{sw}$) variiert werden, sodass der Stromraumzeiger ($i_s$) um einen Winkel von zumindest 360° rotiert.

4. Verfahren nach einem der Ansprüche 1 bis 3, **dadurch gekennzeichnet, dass** die elektrische Periode in Sektoren ($S_n$) unterteilt wird und der Stromraumzeiger ($i_s$) während der Funktionsprüfung in jedem Sektor ($S_n$) für eine bestimmte Verweildauer verbleibt.

## Claims

1. Method for functional testing of a holding brake (2) of an electric motor (1) in which, with the holding brake (2) closed, phase currents ($i_{su}$, $i_{sv}$, $i_{sw}$) are applied to the electric motor (1) in magnitude and angle for producing a current vector ($i_s$) and it is checked whether the holding brake (2) slips when the phase currents ($i_{su}$, $i_{sv}$, $i_{sw}$) are being applied, **characterized in that** the phase currents ($i_{su}$, $i_{sv}$, $i_{sw}$) are varied so that the current vector ($i_s$) is rotated, with the holding brake (2) closed, so that the current vector ($i_s$) is normal to the rotor flux direction (d) at least one time.

2. Method in accordance with claim 1, **characterized in that** the phase currents ($i_{su}$, $i_{sv}$, $i_{sw}$) are varied so that the current vector ($i_s$) rotates by an angle of at least 180°.

3. Method in accordance with claim 1, **characterized in that** the phase currents ($i_{su}$, $i_{sv}$, $i_{sw}$) are varied so that the current vector ($i_s$) rotates by an angle of at least 360°.

4. Method in accordance with any of claims 1 through 3, **characterized in that** the electrical period is divided into sectors ($S_n$) and during the functional testing the current vector (is) remains in each sector ($S_n$) for a defined dwell period.

## Revendications

1. Procédé de contrôle fonctionnel d'un frein d'arrêt (2) d'un moteur électrique (1), dans lequel, lorsque le frein d'arrêt (2) est fermé, des courants de phase ($I_{su}$, $I_{sv}$, $I_{sw}$) sont appliqués au moteur électrique (1) pour produire un vecteur spatial de courant ($I_s$) en amplitude et en angle et l'on vérifie si le frein d'arrêt (2) patine une fois les courants de phase ($I_{su}$, $I_{sv}$, $I_{sw}$) appliqués, **caractérisé en ce que** l'on fait subir une variation aux courants de phase ($I_{su}$, $I_{sv}$, $I_{sw}$) de sorte que le vecteur spatial de courant ($I_s$) soit soumis à une rotation alors que le frein d'arrêt (2) est fermé en sorte que le vecteur spatial de courant ($I_s$) soit au moins une fois normal à la direction de flux (d) du rotor.

2. Procédé selon la revendication 1, **caractérisé en ce que** l'on fait subir une variation aux courants de phase ($I_{su}$, $I_{sv}$, $I_{sw}$) de sorte que le vecteur spatial de courant ($I_s$) tourne d'un angle d'au moins 180°.

3. Procédé selon la revendication 1, **caractérisé en ce que** l'on fait subir une variation aux courants de phase ($I_{su}$, $I_{sv}$, $I_{sw}$) de sorte que le vecteur spatial de courant ($I_s$) tourne d'un angle d'au moins 360°.

4. Procédé selon l'une quelconque des revendications 1 à 3, **caractérisé en ce que** la période électrique est subdivisée en secteurs ($S_n$) et le vecteur spatial de courant ($I_s$) reste, au cours du contrôle fonctionnel, dans chaque secteur ($S_n$) pendant une période de séjour déterminée.

$i_{SU}, i_{SV}, i_{SW}$

$M_L$

$M_W$

7

6

1

2

3

5

4

Fig. 1

Fig. 2

Fig. 3

Fig. 4

Fig. 5

Fig. 6

Fig. 7

Fig. 8

**EP 3 014 233 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005015608 A1
- DE 102007005827 A1

- DE 19756752 A1